# EUROPÄISCHE PATENTANMELDUNG

(11) **EP 4 212 790 A1**
(43) Veröffentlichungstag der Anmeldung: **19.07.2023**
(21) Anmeldenummer: 23150861.5
(22) Anmeldetag: 10.01.2023
(51) Int. Cl.: F24S 25/63, H01L 31/042, F24S 25/40, F24S 30/425, H02S 20/25, H02S 20/32, H02S 20/23

(54) **AUSRICHTBARES FOTOVOLTAIKMODUL, FOTOVOLTAIKMODULANORDNUNG UND FAHRZEUG-LADESTATION**

(30) Priorität: 17.01.2022 DE 102022100979
(71) Anmelder: SB Fine Chemicals Germany GmbH, 17489 Greifswald (DE)
(72) Erfinder: TEWS, Stefan, 17489 Greifswald (DE); WIERZCHOWIEC, Piotr, 79235 Vogtsburg im Kaiserstuhl (DE); MOREIRA, Bruno Duarte, 60528 Frankfurt am Main (DE)
(74) Vertreter: Engel, Christoph Klaus

(57) **Zusammenfassung**

Die Erfindung betrifft ein ausrichtbares Fotovoltaikmodul (01) mit einem mehrere Fotovoltaikzellen enthaltenden Panel (03) sowie mindestens zwei Halterungen (04). Das Panel (03) besitzt ein Längen/Breiteverhältnis >4, wobei maximal zwei Fotovoltaikzellen in der Breitenrichtung des Panels (03) nebeneinander und mindestens zehn Fotovoltaikzellen in der Längenrichtung des Panels aufeinanderfolgend angeordnet sind. Die Halterungen (04) besitzen jeweils einen Kopfbereich (06), an welchem das Panel (03) an seinen Längsseiten befestigt ist, und einen Fußbereich (07) zur Montage auf einem Träger (02). Die Halterung (04) ist als ein profilierter Materialstreifen gebildet ist, der auf der Trägerseite des Panels (03) angebracht ist. Der Fußbereich (07) ist so geformt, dass die Befestigung am Träger (02) in einem veränderlichen Winkel zur Auflagefläche (17) des Trägers erfolgen kann.

Die Erfindung betrifft weiterhin eine Fotovoltaikmodulanordnung zur Erzeugung elektrischer Energie mit mehreren solcher Fotovoltaikmodule (01). Schließlich betrifft die Erfindung eine Fahrzeug-Ladestation (19) mit einer solchen Fotovoltaikmodulanordnung.

## Beschreibung

Die Erfindung betrifft ein ausrichtbares Fotovoltaikmodul mit einem mehrere Fotovoltaikzellen enthaltenden Panel sowie mindestens zwei Halterungen. Weiterhin betrifft die Erfindung eine Fotovoltaikmodulanordnung sowie eine Fahrzeug-Ladestation, die jeweils mehrere solcher Fotovoltaikmodule besitzen.

Fotovoltaikmodule sind in vielfältigen Ausführungsformen und Leistungsstärken bekannt. Diesen Modulen ist gemein, dass sie Fotovoltaikzellen verwenden, welche durch Sonneneinstrahlung eingetragene Photonenenergie unmittelbar in elektrische Energie umwandeln. In den letzten Jahren hat sich der erzielbare Wirkungsgrad von Fotovoltaikzellen verbessert, sodass heute eine Gewinnung von elektrischer Energie durch diese Technologie an vielen Standorten wirtschaftlich ist.

Der globale Solarmarkt ist über die letzten Jahre rasant gewachsen und hat im Jahr 2020 eine kumulierte Leistung von fast 750 GW an installierten Fotovoltaikmodulen erreicht. Regelmäßig werden die Fotovoltaikmodule so aufgestellt, dass ein maximaler Ertrag erreichbar scheint. Komplizierte Anlagen führen dafür die Module dem sich ändernden Sonnenstand nach, jedoch ist dies bei einfachen Anlagen nicht möglich. Bei kleinen und einfachen Fotovoltaikanlagen sind die Module fest verbaut, insbesondere auf Dachflächen und zunehmend auch an Gebäudefassaden. Um bei fest verbauten Modulen den Ertrag zu maximieren, werden diese üblicherweise nach Süden ausgerichtet, sodass die Sonneneinstrahlung zur Mittagszeit nahezu senkrecht auf die Oberfläche der integrierten Fotovoltaikzellen trifft. Dies führt aber auch dazu, dass der meiste Solarstrom um die Mittagszeit produziert wird, was die Netzbetreiber vor große Herausforderungen stellt und Speicherlösungen erfordert oder den erzeugten Solarstrom im schlechtesten Fall nicht vollständig nutzbar macht. Im Bereich von privaten oder gewerblichen Anlagen kann der Solarstrom mittags meist nicht vollständig verbraucht werden, da der Strombedarf häufig auch in den Morgen- sowie Abendstunden entsteht.

Aufgrund der zunehmenden Standardisierung und der Konzentration bei wenigen Herstellern sind die meisten Fotovoltaikmodule heutzutage in gleichen Dimensionen aufgebaut und bestehen zumeist aus 60 oder 72 Fotovoltaikzellen, verschaltet in 6 Reihen mit je 10 Zellen oder 12 Zellen. Dadurch sind die Module typischerweise etwa 1,6 m lang und etwa 1 m breit. Diese Vereinheitlichung erleichtert zwar die Vorhaltung von Montagesystemen, erschwert vor Ort aber auch den Transport und die Montage der Module auf Dächern, schon aufgrund des Gewichts von etwa 12-18 kg pro Modul.

Viele theoretisch denkbare Anwendungen von Fotovoltaikmodulen, zum Beispiel im Agrarbereich, sind durch die Größe der Module und die damit verbundene Verschattung nicht oder nur mit großen Nachteilen umsetzbar. So ist zum Beispiel eine Installation als Sonnenschutz auf Feldern nur schwer möglich, da die Module einen starken Schattenwurf aufzeigen und das Pflanzenwachstum unter ihnen dadurch zu stark gemindert wird. Bei auf Dächern montierten Anlagen wirkt limitierend, dass die Module nur in Richtung der Aufständerung, also meistens in Richtung der Dachneigung, ausgerichtet werden können. Im Falle von ungünstigen Dachorientierungen oder vorherrschender Verschattung fallen somit viele Anwendungsmöglichkeiten weg. Zusätzlich limitiert die standardisierte Größe die optimierte Anpassung an bestehende Dachflächen.

Die US 2015/0092383 A1 zeigt eine Montagehalterung mit einem flexiblen Körper mit mindestens einem oberen Element und einem flexiblen, abgewinkelten unteren Element, das mit dem oberen Element verbunden ist. Der flexible Körper definiert eine Einführungsöffnung zwischen dem oberen Element und dem unteren Element. Die Montagehalterung umfasst weiterhin eine am oberen Element befestigte Klammer und eine Gewindestange, die durch das obere Element verläuft, sowie eine Klemmmutter, die die Gewindestange an dem oberen Element befestigt, so dass durch Drehen der Klemmmutter das obere Element zusammengedrückt und dadurch ein Fotovoltaikmodul, geerdet wird.

Die US 2012/0080071 A1 beschreibt ein System zur automatischen Beschattung eines Parkplatzes und zur Umwandlung von einfallender Energie in Elektrizität. Das System besitzt ein sich vertikal erstreckendes erstes Stützelement, das ein am Boden verankertes proximales Ende und ein gegenüberliegendes distales Ende aufweist. Ein Energieübertragungsabschnitt ist in der Nähe des proximalen Endes angeschlossen. Ein Solarpanel zur Umwandlung von einfallendem Sonnenlicht in Elektrizität und zur Bereitstellung von Parkschatten ist in der Nähe des distalen Endes des ersten Trägerelements angeordnet.

Die US 2009/0145423 A1 zeigt eine Solarpanel-Einheit mit einer Befestigungsstruktur, mindestens einem Solarpanel, das mit der Befestigungsstruktur verbunden ist, und mit einer Gelenkanordnung, die zwischen der Befestigungsstruktur und dem Solarpanel angeordnet ist, um eine Drehung des Solarpanels in Bezug auf die Befestigungsstruktur um eine geneigte Gelenkachse zu ermöglichen, die einen Winkel von weniger als 90° mit einer horizontalen Ebene bildet.

Die US 2017/0294869 A1 offenbart ein ausrichtbares Fotovoltaikmodul mit einem mehrere Fotovoltaikzellen enthaltenden Panel sowie mindestens zwei Halterungen. Die Fotovoltaikmodule werden mit Hilfe von Paaren von links- und rechtsseitigen Verbindern oder Halterungen an einem Drehmomentrohr für Solartracker-Arrays befestigt. Die linksseitigen und rechtsseitigen Verbinder der Photovoltaik-Anlagen verfügen über Ausrichtungsvorsprünge, die mit dem Innenkörper des Drehmomentrohrs verbunden sind und in diesen hineinragen.

Die Aufgabe der vorliegenden Erfindung besteht ausgehend von den aufgezeigten Schwierigkeiten darin, ein verbessertes Fotovoltaikmodul zur Verfügung zu stellen, welches eine flexible und einfache Anpassung seiner Winkelausrichtung gestattet, besonders preiswert und einfach zu montieren ist und weitere Anwendungsgebiete eröffnet.

Diese und weitere Aufgaben werden durch ein ausrichtbares Fotovoltaikmodul gemäß dem beigefügten Anspruch 1 gelöst.

Das erfindungsgemäße ausrichtbare Fotovoltaikmodul besitzt ein Panel, welches mehrere Fotovoltaikzellen enthält. Weiterhin umfasst das Modul mindestens zwei Halterungen zur Befestigung des Panels auf einem Träger, beispielsweise einer Dachfläche oder dergleichen. Das Panel besitzt ein Längen/Breiteverhältnis >4, bevorzugt >8. In der Breitenrichtung, also quer zur Längsachse des Panels, sind maximal zwei Fotovoltaikzellen nebeneinander liegend angeordnet. In der Längenrichtung des Panels sind mindestens zehn Fotovoltaikzellen aufeinanderfolgend angeordnet. Die mindestens zwei Halterungen, die jedem Panel zugeordnet sind, besitzen jeweils einen Kopfbereich, in welchem das Panel an seinen Längsseiten eingespannt ist, und einen Fußbereich zur Montage auf einem Träger. Die Halterung ist als ein profilierter Materialstreifen gebildet und auf der Trägerseite des Panels angeordnet. Der Fußbereich der Halterung ist so geformt, dass die Befestigung am Träger in einem veränderlichen Winkel zur Auflagefläche des Trägers erfolgen kann.

Das erfindungsgemäße Fotovoltaikmodul ist insgesamt deutlich kleiner als die derzeit üblichen Module, insbesondere weicht sein Längen/Breitenverhältnis von den derzeit üblichen Modulen ab, da vorzugsweise nur eine, maximal zwei Reihen von Fotovoltaikzellen nebeneinander im Modul zusammengefasst sind. Die Probleme der großflächigen Verschattung z. B. auf Feldern sowie der gegenseitigen Verschattung von Modulen auf Dächern lassen sich daher durch die erfindungsgemäßen Fotovoltaikmodule vermeiden. Ein weiterer Vorteil der erfindungsgemäßen Fotovoltaikmodule besteht darin, dass diese sehr variabel im Winkel zur Auflagefläche verändert werden können, um die Module z. B. nach Osten oder Westen zu verkippen, sodass sie auch am Morgen bzw. am Abend eine höhere Energieausbeute gestatten.

Die Halterungen stellen einen integralen Bestandteil des Fotovoltaikmoduls dar und gestatten eine direkte Befestigung auf einem Träger, beispielsweise einem Leichtbaudach. Durch das im Modul integrierte Haltesystem werden keine zusätzlichen Halteschienen benötigt, wodurch das Gesamtgewicht der Fotovoltaikanordnung reduziert wird. Zusätzlich kann durch die Halterungen die Ausrichtung jedes einzelnen Panels individuell angepasst werden. Dies ermöglicht es, dass auf einer nach Süden ausgerichteten Fläche einzelne Module verkippt werden können und eine Ausrichtung gen Osten, Südosten, Süden, Südwesten oder Westen für jeweils einzelne Module ausgewählt werden kann. Die gesamte Fotovoltaikanordnung kann dadurch optimal an den Energiebedarf verschiedener Nutzer (Ladestationen für E-Autos, Haushalte, etc.) angepasst werden. Zusätzlich können dadurch auch sonst kaum wirtschaftliche Anwendungsfälle mit Fotovoltaikmodulen ausgestattet werden, wie z. B. ein nach Norden ausgerichtetes Dach, indem man die Module auf der Nordseite selektiv nach Osten oder Westen verkippt.

Gemäß einer bevorzugten Ausführungsform besitzt das Panel eine Längen/Breiteverhältnis >8, wobei in der Breitenrichtung des Panels genau eine Fotovoltaikzelle angeordnet ist. Es handelt sich somit um ein einreihiges Panel, welches bei Verwendung üblicher Fotovoltaikzellen eine Breite von etwa 18-20 cm und eine Länge von beispielsweise 160 cm besitzt. Ein solches Modul wiegt nur etwa 1/5 bis 1/6 eines herkömmlichen Moduls und lässt sich besonders vorteilhaft auf Ziegeldächern installieren.

Eine vorteilhafte Ausführungsform zeichnet sich dadurch aus, dass jede der Halterungen einstückig gebildet ist und vorzugsweise aus einem gebogen Metallstreifen besteht. Alternativ können die Halterungen aus einem profilierten Kunststoff oder auch aus Verbundmaterialien bestehen.

Bevorzugt besitzt der Fußbereich der Halterung eine gekrümmte Montagefläche, die bei der Befestigung am Träger auf dessen Auflagefläche aufgelegt wird. Besonders bevorzugt ist die Montagefläche des Fußbereichs in einem Radius gekrümmt, der dem Radius in typischen Dachziegeln entspricht. Der Winkel, in welchem die fotoempfindliche Oberfläche des Panels liegt, kann in diesem Fall in nahezu beliebig kleinen Schritten an den jeweiligen Anwendungsfall angepasst werden. Alternative Ausführungsformen besitzen einen Fußbereich der Halterung, der einen polygonalen Querschnitt aufweist, sodass mehrere abgeflachte Montageflächen bereitstehen. Der Winkel zur Montage der Panels kann dann in vorgegebenen Schritten gewählt werden. Dies bietet u.a. den Vorteil, dass mehrere Halterungen einfach mit demselben Winkel montiert werden können, ohne dass dieser im Einzelfall nachgemessen werden muss.

Bei einer bevorzugten Ausführungsform sind im Fußbereich der Halterung mehrere Bohrungen angeordnet. Abhängig vom gewählten Winkel zur Auflagefläche wird durch einer dieser Bohrungen eine Schraube oder ein ähnliches Befestigungselement geführt und im Träger befestigt.

Mit einer der vorgenannten Ausführungsformen oder mit Kombinationen aus ihnen lassen sich unterschiedlichste Fotovoltaikmodulanordnungen zur Erzeugung elektrischer Energie aufbauen. Eine derartige Fotovoltaikmodulanordnung umfasst mehrere Fotovoltaikmodule, welche mit ihren Halterungen unmittelbar oder mittelbar beispielsweise auf einer Dachfläche, an einer Fassade oder an einem sonstigen Träger angebracht sind. Durch die winkelveränderliche Befestigung mithilfe der Halterungen der einzelnen Module ist es möglich, dass trotz Verwendung gleicher Fotovoltaikmodule der Winkel einiger oder aller Module gegenüber den Träger veränderlich ist. Bevorzugt nehmen nach der Montage mindestens einige dieser Fotovoltaikmodule einen anderen Winkel gegenüber der Dach- oder Trägerfläche ein als andere Fotovoltaikmodule derselben Fotovoltaikmodulanordnung.

Eine besonders bevorzugte Ausführungsform der genannten Fotovoltaikmodulanordnung ist in der Art einer Fahrzeug-Ladestation realisiert. Die Fahrzeug-Ladestation umfasst eine Fotovoltaikmodulanordnung zur Erzeugung elektrischer Energie, die mehrere Fotovoltaikmodule besitzt, welche mit ihren Halterungen an Seitenauslegern eines Hauptträgers angebracht sind. Zumindest mehrere der Fotovoltaikmodule verlaufen im Wesentlichen parallel zueinander, um eine Beschattungsfläche zu bilden, unter welcher ein beschatteter Raum verbleibt, zum Abstellen eines zu ladenden Fahrzeugs. Die Fahrzeug-Ladestation umfasst weiterhin eine Steuerschaltung und einen elektrischen Speicher, die zum Laden eines Elektrofahrzeugs konfiguriert sind.

Ein Vorteil der individuellen Orientierung der Fotovoltaikmodule liegt in der Anpassung des Stromertrags über den Tagesverlauf. Durch die einstellbaren Winkel können die Module individuell zwischen 15 und 165 Grad im Bogenmaß verkippt und auf dem Dach oder einem ähnlichen Träger fixiert werden. Auf einer nach Süden ausgerichteten Fläche können dadurch Orientierungen nach Osten, Süden sowie Westen realisiert werden. Auf einer nach Osten ausgerichteten Fläche kann somit eine Orientierung nach Norden, Osten und Süden erreicht werden, um einen höheren Stromertrag am Mittag zu erzielen, falls benötigt. Vorteilhaft ist außerdem die Möglichkeit nach Norden ausgerichtete Flächen zu nutzen, da durch die Verkippung eine Orientierung nach Osten, Norden und Westen erzielt werden kann.

Durch die schmale Bauart der Fotovoltaikmodule entsteht selbst bei starker Verkippung nahezu keinerlei Verschattung zwischen den Modulen. Beim Einsatz von bifacialen Glas-Glas Modulen erhält man zusätzlich einen deutlich höheren Stromertrag durch die Verkippung, da die Rückseite im Vergleich zu einer normalen Aufdachanlage ertragreich mitgenutzt werden kann.

Um eine stärkere Neigung der Module zu erhalten, kann die Halterung auch unterschiedliche Höhen besitzen. Die erzielbare Energieausbeute hängt stark von der Ausrichtung ab. Somit kann die Erzeugung von Solarstrom mit den erfindungsgemäßen Fotovoltaikmodulen auf das Nutzerverhalten abgestimmt werden.

Nachfolgend werden weitere Ausführungsformen genannt, in denen die erfindungsgemäßen Fotovoltaikmodule Anwendung finden können.

Eine Ausführungsform betrifft sogenannte Solar-Zäune. Diese dienen nicht nur der Absicherung von Grundstücken sondern auch der Erzeugung von Solarstrom. Durch die Halterung und das schmale Modulsystem können die einzelnen Panels ausgerichtet werden, sodass zwischen ihnen kleine Freiräume verbleiben, durch die Wind abgeführt und z. B. Insekten und Nager gelangen können. Gleichzeitig erinnert das Design dadurch an das Erscheinungsbild klassischer Zäune.

Eine andere Ausführungsform dient dem Wind und Lärmschutz auf Straßen. Die Fotovoltaikmodule können z. B. vertikal an den Seiten von Autobahnen installiert werden. Durch die individuelle Ausrichtung können bifaciale Module generell nach Osten/Westen ausgerichtet werden, selbst wenn die Straßenführung zunächst eine Nordausrichtung nötig erscheinen lässt. Zusätzlich kann durch die Verwendung längerer und kürzerer Halterungen eine Neigung in Längsrichtung der Module eingestellt werden.

Eine abgewandelte Ausführungsform dient als Fahrbahnabtrennung, insbesondere um Blendlicht zu vermeiden. Vertikal installierte Fotovoltaikmodule werden dazu zwischen zwei Fahrbahnen oder auf den Mittelleitplanken angebracht, wobei sie tagsüber zur generellen Stromerzeugung beitragen. Durch die individuell anpassbare Orientierung und die schmale Bauart der Module kann dem Fahrbahnverlauf optimal gefolgt und gleichzeitig der Stromertrag optimiert werden.

Die Fotovoltaikmodule können an der oberen Kante von äußeren Gebäudewänden angebracht werden, sodass sie sowohl der Energiegewinnung als auch dem Wetterschutz dienen. Ebenso können die Fotovoltaikmodule für den Sonnenschutz eingesetzt werden, wenn sie über Balkonen oder Fenstern angebracht werden. Ebenso lassen sich die Fotovoltaikmodule als Balkon- oder Terrassenabtrennung verwenden, anstelle von Glasabtrennungen oder Abtrennungen aus Holz. Besonders eignen sich auch hier bifaciale Fotovoltaikzellen. Ein Vorteil ist hierbei die einfache Anpassung an die abzutrennende Fläche. Die Fotovoltaikmodule, insbesondere wenn bifaciale Zellen genutzt werden, eignen sich ebenfalls als Überdachung von Carports und Pergolen.

Gemäß einer abgewandelten Ausführungsform können die Fotovoltaikmodule auf einer Metallkonstruktion so über Nutzpflanzen montiert werden, dass die Konstruktion den Pflanzen Schutz vor starker Sonneneinstrahlung, Hagel, starkem Regen und zu starker Verdunstung von Wasser aus dem Boden bietet. Ein weiterer Vorteil der beschriebenen Module (insbesondere bei bifacialen Panels) ist eine homogene Lichtverteilung für die Pflanzen, um längere Beschattung oder Sonnenbrand zu vermeiden, insbesondere wenn die Module in geringerer Höhe über den Pflanzen aufgehängt sind. Dadurch bekommen die Pflanzen mehr Sonnenlicht bei gleicher erreichbarer Fotovoltaik-Leistung. Die Fotovoltaikmodule können auch an Bewässerungsleitungen montiert oder mit diesen kombiniert werden, die über den Pflanzenkulturen angebracht sind.

Eine weitergebildete Ausführungsform zeichnet sich dadurch aus, dass mehrere Fotovoltaikmodule zu faltbare Anordnungen zusammengefügt sind. Dies eignet sich z. B. zur mobilen Nutzung an Wohnwagen, Wohnmobilen oder dergleichen. An den länglichen Modulen sind dafür Scharniere angebracht.

Gemäß einer nochmals abgewandelten Ausführungsform können die einzelnen Fotovoltaikmodule oder auch Gruppen aus solchen Modulen automatisch nach dem jeweiligen Sonnenstand ausgerichtet werden. Eine Winkelnachführung erfolgt durch Drehung um die Längsachse der Panels. Dazu sind die Halterungen auf einer Dreheinheit gelagert oder bilden einen Bestandteil der Dreheinheit. Das kompakte Design der Module reduziert die Schattenbildung zwischen den Modulen und ermöglicht so eine bessere Raum- und Sonnennutzung. Die universelle Halterung ermöglicht auch die Installation der Panels an vertikalen Konstruktionen, zum Beispiel Wänden, mit der besten Winkelausrichtung, um die Sonneneinstrahlung zu maximieren.

Weitere Vorteile und Einzelheiten ergeben sich aus der nachfolgenden Beschreibung bevorzugter Ausführungsformen der Erfindung, unter Bezugnahme auf die Zeichnung. Es zeigen:
- Fig. 1: eine vereinfachte perspektivische Darstellung einer Ausführungsform eines erfindungsgemäßen Fotovoltaikmoduls, welches auf einem Ziegeldach angebracht ist;
- Fig. 2: eine Halterung des Fotovoltaikmoduls in drei verschiedenen Ansichten;
- Fig. 3: eine vereinfachte perspektivische Darstellung einer Ausführungsform einer Fotovoltaikmodulanordnung zur Erzeugung elektrischer Energie, die Ständer als Träger verwendet;
- Fig. 4: eine vereinfachte Seitenansicht einer Fahrzeug-Ladestation mit einer Fotovoltaikmodulanordnung;
- Fig. 5: eine Draufsicht auf die Fahrzeug-Ladestation gemäß Fig. 4.

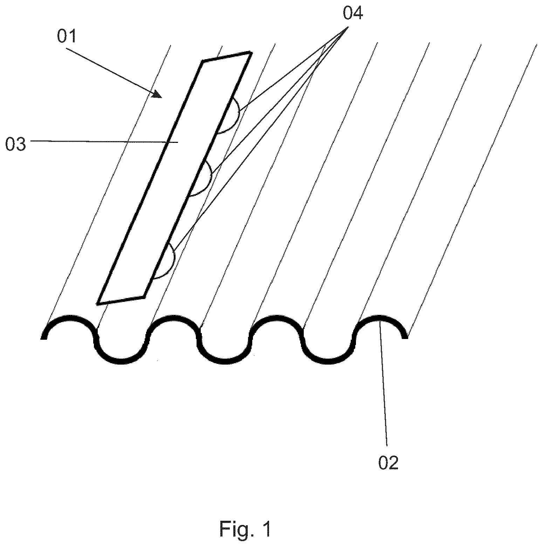

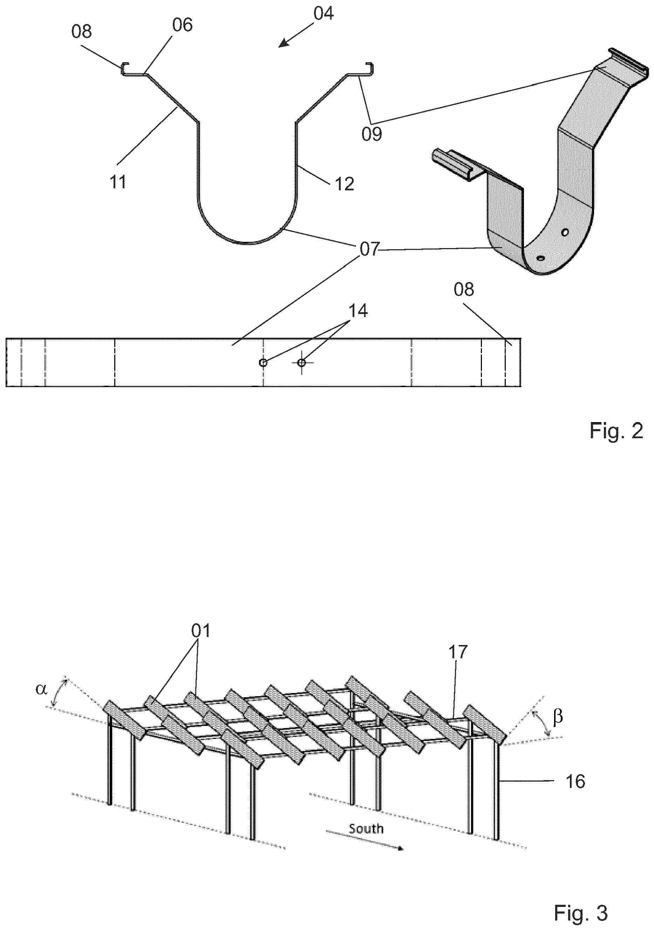

Fig. 1 zeigt in vereinfachter perspektivischer Darstellung eine Ausführungsform eines Fotovoltaikmoduls 01, welches auf einer geneigten Ziegeldachfläche 02 angeordnet ist. Das Modul 01 umfasst ein Panel 03, in welchem beispielsweise 10 oder 12 Fotovoltaikzellen zusammengefasst sind. Das Panel ist lang gestreckt, da alle Zellen in der gezeigten Ausführungsform in einer einzigen Reihe angeordnet sind. Damit ergibt sich ein Längen/Breitenverhältnis des Panels >8. Weiterhin umfasst das Fotovoltaikmodul 01 drei Halterungen 04, die in Fig. 2 detaillierter dargestellt sind.

Die Halterungen können in ihren Abmessungen und Formgebungen an die Träger und an die einzusetzenden Panels angepasst werden. Als Fotovoltaikzellen kommen beispielsweise in Betracht:
- allgemein kristalline Silizium-Solarzellen (z.B. AlBSF, PERC, Bifacial, IBC, HIT);
- Cadmium-Telluride Solarzellen (CdTe);
- Copper-Indium-Gallium-Diselenide (CIGS/CIS);
- Amorphe Silizium Solarzellen (a-Si);
- III/V Solarzellen wie Gallium-Arsenide (GaAs) Solarzellen oder multi-junction Solarzellen basierend auf Germanium/Indium-(Aluminium)-Gallium-Arsenide oder phosphide (In(Al)GaAs/P) ;
- Dye sensitized Solarzellen (DSSC);
- Organische Solarzellen (OSC);
- Perovskite Solarzellen (PSC);
- Quantum dot Solarzellen (QSC);
- Allgemein II/VI Solarzellen wie Zinkselenide (ZnSe) oder Eisensulfide (FeS);
- Tandem Solarzellen.

Aus Fig. 1 ist bereits ersichtlich, dass die Halterung 04 in den Mulden der Dachziegel befestigt wird, beispielsweise durch Schrauben. Dabei kann der Winkel zwischen der Oberfläche des Panels und der Dachfläche durch Verschwenken der Halterung leicht angepasst werden.

Fig. 2 zeigt die Halterung 04 in einer Querschnittsansicht, einer perspektivischen Ansicht und einer Ansicht von unten. Die Halterung besteht bei dieser Ausführungsform aus einem gebogenen Metallstreifen. Sie besitzt einen Kopfbereich 06 und einen Fußbereich 07. Am Kopfbereich 06 sind an den Außenkanten jeweils Krallen 08 angeformt, zwischen denen das Panel 03 eingeklemmt bzw. gehaltert wird. Die Verbindung zwischen dem Kopfbereich 07 und dem Panel kann durch Federkräfte, Klebstoffe, Halteklemmen oder andere geeignete Verbindungselemente hergestellt sein. Der Kopfbereich 06 besitzt eine Breite, die an das zu haltende Panel 03 angepasst ist, beispielsweise etwa 20 cm. Die in Fig. 2 gezeigte Ausführung der Halterung 04 besitzt beispielsweise eine Gesamthöhe von etwa 14 cm, eine Tiefe von etwa 4 cm und im Fußbereich 07 eine Breite von etwa 8 cm.

Ausgehend von den Krallen 08 erstreckt sich der Kopfbereich jeweils in einen Tragabschnitt 09, der die Auflage für das Panel 03 bildet. Der Tragabschnitt 09 geht dann winklig in einen Stützabschnitt 11 über, wobei die beiden gegenüberliegenden Stützabschnitte 11 aufeinander zulaufen und jeweils in einen Verlängerungsabschnitt 12 des Fußbereichs 07 übergehen. Die beiden Verlängerungsabschnitte 12 gehen dann in einen Montageabschnitt 13 über, der in der dargestellten Ausführungsform eine gleichmäßig gekrümmte Form aufweist, sodass der Montageabschnitt 13 einen Halbkreis mit einem Radius von z.B. 40 mm beschreibt. Der Montageabschnitt ist passend zu der vorgesehen Trägerfläche 02 geformt, kann bei anderen Ausführungsformen also auch polygonal oder ähnlich ausgebildet sein.

In jedem Fall gestattet die Montagefläche 13 die Winkeleinstellung gegenüber der Trägerfläche. Bei der in Fig. 2 dargestellten Ausführungsform sind dazu im Bereich der Montagefläche 13 mehrere Bohrungen 14 angebracht, die je nach gewähltem Winkel zur Befestigung ausgewählt werden.

Fig. 3 zeigt in perspektivischer Ansicht eine Ausführungsform einer Fotovoltaikmodulanordnung zur Erzeugung elektrischer Energie. Die Anordnung umfasst mehrere Fotovoltaikmodule 01, welche mit ihren Halterungen 04 an einem Trägergestell 16 angebracht sind. Die Fotovoltaikmodule 01 sind mit veränderlichem Winkel gegenüber der Auflagefläche des Trägergestells 16 angeordnet. Das Trägergestell bildet an seinen Auflageflächen 17 die Trägerfläche 02 für die einzelnen Module 01. In an sich bekannter Weise sind die Module 01 mit einem Winkel α in Südrichtung geneigt. Diese Winkelstellung wird durch die in unterschiedlicher Höhe verlaufenden Auflageflächen für alle Module gleichmäßig definiert. Darüber hinaus sind die Module jeweils einzeln um einen Winkel β nach Westen geneigt. Diese Winkelstellung ist für jedes Modul 01 separat einstellbar, mithilfe der Neigung der Halterungen 04 gegenüber den Auflageflächen 17.

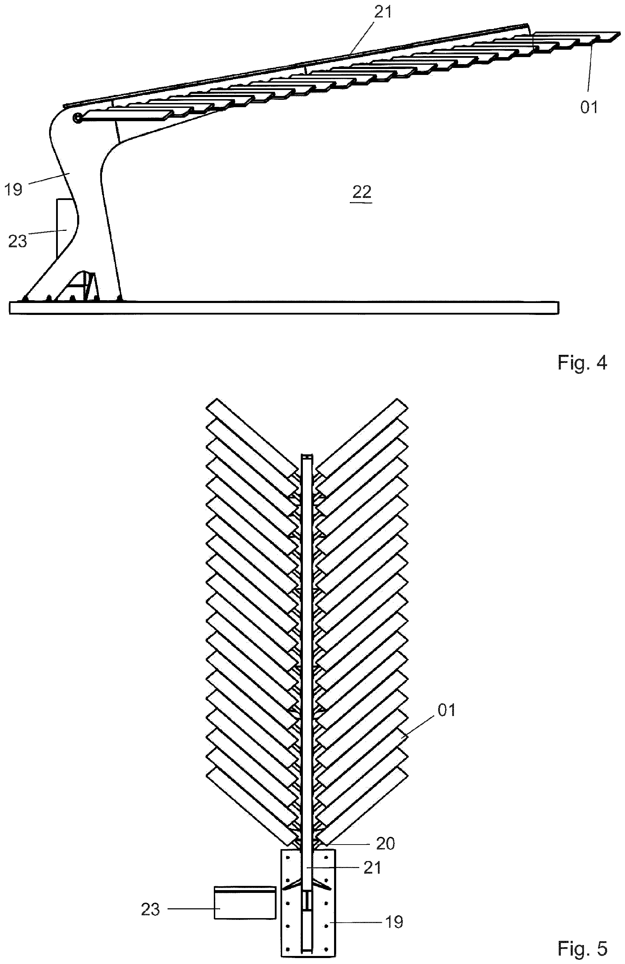

Fig. 4 zeigt in Seitenansicht, Fig. 5 in Draufsicht einen besonderen Anwendungsfall für die beschriebenen Fotovoltaikmodule, nämlich eine Fahrzeug-Ladestation 19 umfassend eine Fotovoltaikmodulanordnung zur Erzeugung elektrischer Energie. Die mehreren Fotovoltaikmodule 01 sind mit ihren Halterungen an Seitenauslegern 20 eines Hauptträgers 21 angebracht. Die Fotovoltaikmodule 01 sind im Wesentlichen parallel zueinander verlaufend angebracht, um eine Beschattungsfläche zu bilden, unter welcher ein beschatteter Raum 22 verbleibt, zum Abstellen eines zu ladenden Fahrzeugs. Die Fahrzeug-Ladestation 19 besitzt weiterhin eine Steuerschaltung und einen elektrischen Speicher 23, die zum Laden eines Elektrofahrzeugs konfiguriert sind.

Es ist ersichtlich, dass die Fotovoltaikmodule an der Fahrzeug-Aufladestation ausgerichtet werden können, um sowohl die gewünschte elektrische Energie zu generieren als auch die Beschattung des zu ladenden Fahrzeugs, insbesondere bei hochstehender Sonne zu gewährleisten.

### Bezugszeichen

- 01: Fotovoltaikmodul
- 02: Träger / Dachfläche
- 03: Panel
- 04: Halterung
- 05: --
- 06: Kopfbereich der Halterung
- 07: Fußbereich der Halterung
- 08: Krallen der Halterung
- 09: Tragabschnitt der Halterung
- 10: --
- 11: Stützabschnitt
- 12: Verlängerungsabschnitt
- 13: Montagefläche
- 14: Bohrung
- 15: --
- 16: Trägergestell
- 17: Auflagefläche
- 18: --
- 19: Fahrzeug-Aufladestation
- 20: Seitenausleger
- 21: Hauptträger
- 22: beschatteter Raum
- 23: elektrischer Speicher

## Patentansprüche

1. Ausrichtbares Fotovoltaikmodul (01) mit einem mehrere Fotovoltaikzellen enthaltenden Panel (03) sowie mindestens zwei Halterungen (04), **dadurch gekennzeichnet, dass**
- das Panel (03) ein Längen/Breiteverhältnis >4 besitzt, wobei maximal zwei Fotovoltaikzellen in der Breitenrichtung des Panels (03) nebeneinander und mindestens zehn Fotovoltaikzellen in der Längenrichtung des Panels aufeinanderfolgend angeordnet sind;
- die mindestens zwei Halterungen (04) jeweils einen Kopfbereich (06), an welchem das Panel (03) an seinen Längsseiten befestigt ist, und einen Fußbereich (07) zur Montage auf einem Träger (02) besitzen, wobei die Halterung (04) als ein profilierter Materialstreifen gebildet ist, der auf der Trägerseite des Panels (03) angebracht ist, wobei der Fußbereich (07) so geformt ist, dass die Befestigung am Träger (02) in einem veränderlichen Winkel zur Auflagefläche (17) des Trägers erfolgen kann.

2. Fotovoltaikmodul (01) nach Anspruch 1, **dadurch gekennzeichnet, dass** das Panel (03) ein Längen/Breiteverhältnis >8 besitzt, wobei in der Breitenrichtung des Panels (03) genau eine Fotovoltaikzelle angeordnet ist.

3. Fotovoltaikmodul (01) nach Anspruch 1 oder 2, **dadurch gekennzeichnet, dass** jede der Halterungen (04) einstückig gebildet ist und aus einem gebogen Metallstreifen oder einem profilierten Kunststoff besteht.

4. Fotovoltaikmodul (01) nach einem der Ansprüche 1 bis 3, **dadurch gekennzeichnet, dass** der Fußbereich (07) der Halterung (04) eine gekrümmte Montagefläche (13) aufweist, die bei der Befestigung am Träger (02) auf dessen Auflagefläche (17) aufgelegt wird.

5. Fotovoltaikmodul (01) nach einem der Ansprüche 1 bis 4, **dadurch gekennzeichnet, dass** der Fußbereich (07) der Halterung (04) mehrere Bohrungen (14) aufweist, wobei abhängig vom gewählten Winkel zur Auflagefläche (17) durch eine dieser Bohrungen (14) eine Schraube oder ein ähnliches Befestigungselement führbar und im Träger (02) festlegbar ist.

6. Fotovoltaikmodulanordnung zur Erzeugung elektrischer Energie, umfassend mehrere Fotovoltaikmodule (01) gemäß einem der Ansprüche 1 bis 5, welche mit ihren Halterungen (04) unmittelbar oder mittelbar an einem Träger (02) angebracht sind, wobei die Fotovoltaikmodule (01) mit veränderlichem Winkel gegenüber der Auflagefläche (17) des Trägers (02) an diesem festlegbar sind.

7. Fotovoltaikmodulanordnung nach Anspruch 6, **dadurch gekennzeichnet, dass** mindestens einige der Fotovoltaikmodule (01) einen anderen Winkel gegenüber der Auflagefläche (17) einnehmen als andere Fotovoltaikmodule der Fotovoltaikmodulanordnung.

8. Fotovoltaikmodulanordnung nach Anspruch 6 oder 7, **dadurch gekennzeichnet, dass** der Träger durch eine mit Ziegeln gedeckte Dachfläche (02) gebildet ist.

9. Fahrzeug-Ladestation (19) umfassend eine Fotovoltaikmodulanordnung zur Erzeugung elektrischer Energie, die mehrere Fotovoltaikmodule (01) gemäß einem der Ansprüche 1 bis 5 besitzt, welche mit ihren Halterungen (04) an Seitenauslegern (20) eines Hauptträgers (21) angebracht sind, wobei zumindest mehrere der Fotovoltaikmodule (01) im wesentlichen parallel zueinander verlaufen, um eine Beschattungsfläche zu bilden, unter welcher ein beschatteter Raum (22) verbleibt, zum Abstellen eines Elektrofahrzeugs, wobei die Fahrzeug-Ladestation weiterhin eine Steuerschaltung und einen elektrischen Speicher (23) umfasst, die zum Laden des Elektrofahrzeugs konfiguriert sind.
